# EUROPÄISCHE PATENTSCHRIFT

(11) **EP 0 517 727 B1**
(45) Veröffentlichungstag und Bekanntmachung des Hinweises auf die Patenterteilung: **26.10.1994**
(21) Anmeldenummer: 91904136.8
(22) Anmeldetag: 26.02.1991
(51) Int. Cl.: H01L 21/76, H01L 21/265

(54) **VERFAHREN ZUM ERZEUGEN EINER ISOLIERTEN, EINKRISTALLINEN SILIZIUMINSEL**
PROCESS FOR PRODUCING AN INSULATED MONOCRYSTALLINE SILICON ISLAND
PROCEDE DE PRODUCTION D'UN ILOT DE SILICIUM MONOCRISTALLIN ISOLE

(30) Priorität: 27.02.1990 DE 4006158
(43) Veröffentlichungstag der Anmeldung: 16.12.1992
(73) Patentinhaber: FRAUNHOFER-GESELLSCHAFT ZUR FÖRDERUNG DER ANGEWANDTEN FORSCHUNG E.V., 80636 München (DE)
(72) Erfinder: VOGT, Holger, D-4330 Mülheim 13 (DE)
(74) Vertreter: Schoppe, Fritz, Dipl.-Ing.
(86) Internationale Anmeldenummer: DE9100162
(87) Internationale Veröffentlichungsnummer: WO9113463

(56) Entgegenhaltungen:
- US-A- 3 976 511
- US-A- 4 948 742
- PATENT ABSTRACTS OF JAPAN Vol. 7, No. 218 (E-200)(1363), 28 September 1983 ; & JP-A-58 111 345

## Beschreibung

Die vorliegende Erfindung befaßt sich mit einem Verfahren zum Erzeugen einer isolierten, einkristallinen Siliziuminsel. Der Erfindungsgegenstand ist somit ein verfahrensmäßiger Bestandteil des Herstellungsprozesses einer integrierten mikroelektronischen Schaltung.

Aus der Fachzeitschrift Electronics, 26. November 1987, Seiten 127 bis 129 sowie aus der US-A-38 97 274 sind bereits Verfahren zum Erzeugen isolierter Siliziuminseln bekannt, bei denen eine vergrabene Siliziumdioxidschicht zur Isolation der Siliziuminsel durch Ionenimplantation erzeugt wird, woraufhin eine Trenchätzmaske zur Definition der Trenches zur lateralen Begrenzung der Siliziuminsel gebildet wird, mit deren Hilfe Trenches bis zu der vergrabenen Siliziumdioxidschicht geätzt werden, welche anschließend mit einem Dielektrikum aufgefüllt werden. Bei dem Verfahren nach der US-A-38 97 274 wird die Sauerstoffimplantation innerhalb der epitaxial aufgewachsenen Schichten durchgeführt, so daß ein anschließendes Hochtemperatur-Ausheilverfahren erforderlich wird, bei dem die Dotierungen der verschiedenen Schichten ineinander verlaufen, so daß man in der Wahl der gewünschten Dotierfolgen stark eingeschränkt ist. Alternativ ist es für den Fall von niedrigen gewünschten Beschleunigungsspannungen beschrieben, ausgehend von einem hochdotierten Substrat zunächst die Sauerstoffimplantation vorzunehmen, um sodann epitaxial aufgewachsene Schichten zu erzeugen. Wenn eine niedrige Dotierung des Substrates gefordert ist, ist diese Verfahrensalternative nicht anwendbar.

Aus der EP-A-03 28 331 A2 ist es bekannt, bei dem Ätzen von Trenches eine Trenchätzmaske vorzusehen, die Trenches bis zu einer vergrabenen Oxidschicht zu ätzen, eine hohe Dotierung in die Trenchseitenwände einzubringen, um sodann die Trenches zu isolieren und aufzufüllen.

Aus der EP-A-03 25 161 A2 ist es bekannt, zum Auffüllen der Trenches Polysilizium zu verwenden.

Aus der DE-A1-24 51 861 ist bereits ein Verfahren zum Erzeugen einer isolierten, einkristallinen Siliziuminsel innerhalb eines Siliziumsubstrates bekannt, bei dem die Siliziuminsel gegenüber dem Substrat durch eine dielektrische Isolationsschicht getrennt ist. Für die Erzeugung einer derartigen Struktur werden zunächst im wesentlichen V-förmige Gräben mittels anisotropen Ätzens erzeugt. Nunmehr kann, wenn dies gewünscht ist, eine n⁺-Schicht eindiffundiert werden. Anschließend wird eine isolierende Oxidschicht aufgewachsen. Nunmehr wird eine Polysiliziumschicht mit einer Schichtdicke von ungefähr 250 Mikrometer abgeschieden, die die spätere Substratschicht bildet. Die einkristalline Siliziumschicht wird nun mechanisch abgeschliffen, bis die Inseln isoliert sind. In diese Inseln können laterale Niederspannungsbauelemente oder Leistungsbauelemente integriert werden. Das Erzeugen vertikaler Bauelemente ist nicht möglich, da das durch Abscheiden von Polysilizium gemäß dem oben beschriebenen Verfahrensschritt erzeugte Substrat eine polykristalline Struktur hat. Ein weiterer Nachteil dieses bekannten Verfahrens zum Erzeugen von isolierten, einkristallinen Siliziuminseln besteht darin, daß zu seiner Durchführung Prozeßschritte erforderlich sind, die sich nur schwer in ein übliches Fertigungsverfahren für integrierte Schaltungen eingliedern lassen. Ferner ist diese bekannte Technologie sehr kostenaufwendig.

Aus der Fachveröffentlichung Y. Ohata, T. Izumita: "Dielectrically Isolated Intelligent Power Switch", IEEE Cust. Int. Circ. Conf. 1987, Seiten 443 bis 446 ist ein weiteres Verfahren zum Erzeugen isolierter Siliziuminseln bekannt. Bei diesem Verfahren erfolgt die Isolation mittels Trenches. Für die Herstellung eines Leistungsschalters mit der in dieser Fachveröffentlichung dargestellten Struktur bedarf es der Verfahrensschritte des Waferbondens, des Ätzens der epitaxialen Schicht sowie der Oxidschicht über dem später auszubildenden vertikalen Leistungstransistor sowie der anschließenden Epitaxie eines n-Gebietes des Leistungstransistors. Der für dieses bekannte Verfahren wesentliche, nunmehr folgende Verfahrensschritt des Schleifens und Läppens der Waferoberfläche ist in einer Fertigung für integrierte Schaltungen unüblich, so daß das dort beschriebene Herstellungsverfahren unter dem Gesichtspunkt der fehlenden Kompatibilität zu anderen Herstellungsschritten innerhalb der Gesamtfertigung einer integrierten Schaltung nicht zu befriedigen vermag.

Aus der Fachveröffentlichung I.G. Stoev et al., "Formation Of Etch-Stop Structures Utilizing Ion-Beam Synthesized Buried Oxide And Nitride Layers In Silicon", Sensors and Actuators, Band 19, 1989, Seiten 183 bis 197 ist es bekannt, implantierte Oxidschichten als Ätzstopp beim Ätzen von Membranen zu verwenden.

Aus der Fachveröffentlichung F. S. Becker et al., "Low Pressure Deposition Of TEOS Arsenosilicateglass (AsSG) For Trench Doping", ECS Ext. Abstr. Proc., Band 86-2, 1986, Seiten 396 ff. ist eine Dotierstoffbelegung von Trenches mit Arsen bekannt. Ebenso ist in dieser Fachveröffentlichung das Auffüllen von Trenches mit Polysilizium oder abgeschiedenem Oxid (TEOS) beschrieben.

Aus der Fachveröffentlichung A. Andreini et al., "A New Integrated Silicon Gate Technology Combining Bipolar Linear, CMOS Logic, and DMOS Power Parts", IEEE Tr. Elec. Dev., Band ED-33, Nummer 12, 1986, Seiten 2025 bis 2030 ist ein BCDMOS-Verfahren zum Herstellen von integrierten Schaltungen mit mittels BCDMOS-Isolation isolierten Bereichen bekannt, bei dem mittels drei getrennter Masken zunächst eine mittels Implantation vergrabene n⁺-Schicht erzeugt wird, woraufhin eine p⁺-Trenndiffusion durchgeführt wird, auf die eine n⁺-Anschlußdiffusion folgt. Die BCDMOS-Isolation hat einen hohen Platzbedarf und bewirkt keine dielektrische Trennung. Es können Einflüsse von parasitären pn-Übergängen auftreten. Ferner kann im BCDMOS-Prozeß kein vertikaler Hochleistungstransistor integriert werden.

Die US-A-3976511 zeigt ein Verfahren zum Erzeugen einer isolierten, einkristallinen Siliziumschicht, bei dem zunächst ausgehend von einem Substrat mit einer Dotierung von ungefähr 2 x 10¹⁶ Atomen/cm³ durch Sauerstoffimplantation eine vergrabene, elektrisch isolierende SiO₂-Schicht erzeugt wird. Nach einem thermischen Ausheilen der sich ergebenen Schichtstruktur wird eine monokristalline Epitaxieschicht aufgewachsen. Nach diesem Verfahrensschritt wird die Siliziumscheibe umgedreht, woraufhin die ehemalige Substratschicht durch Ätzen entfernt wird. Hierbei dient der vergrabene Isolator als Ätzstopp. Es ergeben sich isolierte, einkristalline Siliziuminseln. Dieses Verfahren ist nicht an den standardmäßigen Herstellungsprozeß für integrierte elektronische Schaltungen angepaßt.

Ausgehend von diesem Stand der Technik liegt der vorliegenden Erfindung die Aufgabe zugrunde, ein Verfahren zum Erzeugen einer isolierten, einkristallinen Siliziuminsel anzugeben, das sich einerseits in den Herstellungsprozeß für integrierte elektronische Schaltungen problemlos einfügen läßt und das andererseits eine verbesserte elektrische Isolation der erzeugten Siliziuminsel ergibt.

Diese Aufgabe wird bei einem Verfahren zum Erzeugen einer isolierten, einkristallinen Siliziuminsel mit den in den Patentansprüchen 1 bzw. 2 angegebenen Verfahrensschritten gelöst.

Bevorzugte Ausgestaltungen und Weiterbildungen des erfindungsgemäßen Verfahrens sind in den Unteransprüchen angegeben.

Nachfolgend werden unter Bezugnahme auf die beiliegenden Zeichnungen Ausführungsbeispiele des erfindungsgemäßen Verfahrens und mittels des erfindungsgemäßen Verfahrens erzeugte Schaltungsstrukturen näher erläutert. Es zeigen:
- Fig. 1 bis 3: Schnittdarstellungen durch eine erste Halbleiterscheibe im Verlaufe eines ersten Ausführungsbeispiels des erfindungsgemäßen Verfahrens zum Erzeugen der isolierten Siliziuminsel;
- Fig. 4: eine Schnittdarstellung durch eine zweite Halbleiterscheibe, bei der die Siliziuminsel mittels eines zweiten Ausführungsbeispieles des erfindungsgemäßen Verfahrens erzeugt wird;
- Fig. 5: eine Schnittdarstellung durch eine dritte Halbleiterscheibe, bei der die Siliziuminsel mittels eines dritten Ausführungsbeispieles des erfindungsgemäßen Verfahrens erzeugt wird;
- Fig. 6: eine Schnittdarstellung durch eine vierte Halbleiterscheibe, bei der die Siliziuminsel mittels eines vierten Ausführungsbeispieles des erfindungsgemäßen Verfahrens erzeugt wird;
- Fig. 7: eine Draufsicht auf die vierte Halbleiterscheibe mit der Siliziuminsel gemäß Fig. 6; und
- Fig. 8: eine Schnittdarstellung durch eine fünfte Halbleiterscheibe, bei der die Siliziuminsel mittels eines fünften Ausführungsbeispieles des erfindungsgemäßen Verfahrens erzeugt wird.

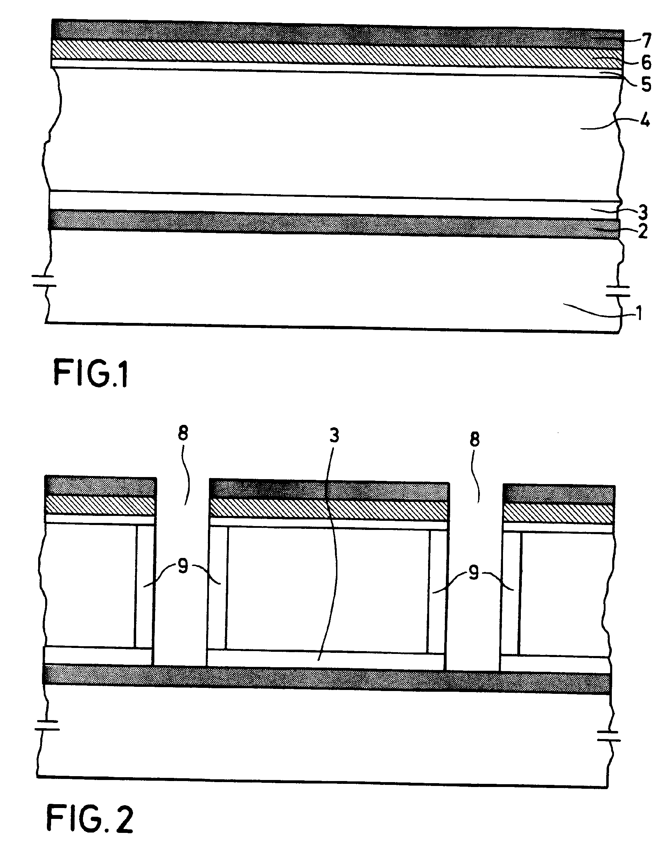

Bei der in den Figuren 1 bis 3 gezeigten, ersten bevorzugten Ausführungsform des erfindungsgemäßen Verfahrens beginnt der Prozeßablauf zum Herstellen der isolierten, einkristallinen Siliziuminsel mit der Wahl eines hochdotierten, einkristallinen Substrates 1. Im Fall eines n⁺-Substrates 1 kann dieses mit Arsen oder Antimon dotiert sein. Im Falle eines p⁺-dotierten Substrates können die Dotierstoffe Bor umfassen. Falls ein hochdotiertes Substrat nicht erwünscht ist, kann auch ein niedrigdotiertes Substrat verwendet werden, dessen oberflächennahe Schicht durch Ionenimplantation hochdotiert wird und anschließend ausgeheilt wird. In diesem Fall ist die Dotierung der oberflächennahen Schicht vor der nachfolgend erläuterten Sauerstoffimplantation durchzuführen, da eine auf einem vergrabenen Isolator liegende Siliziumschicht während der Dotierstoffimplantation amorphisiert wird und nicht mehr einkristallin ausheilt.

Ausgehend von diesem hochdotierten Substrat 1 bei der in Fig. 1 gezeigten Ausführungsform oder ausgehend von dem niedrigdotierten Substrat mit hochdotierter oberflächennaher Schicht (nicht dargestellt) wird nunmehr eine Sauerstoffimplantation zum Erzeugen einer vergrabenen, isolierenden SiO₂-Schicht 2 vorgenommen. Hierdurch wird die durch die vergrabene, isolierende SiO₂-Schicht 2 isolierte, n⁺-Siliziumschicht 3 definiert.

Nunmehr erfolgt ein thermisches Ausheilen des auf diese Weise erzeugten Schichtensystemes 1, 2, 3, so daß die n⁺-Siliziumschicht 3 zu einer hochwertigen, einkristallinen Schicht mit niedrigem Widerstand wird.

Nun wird eine Siliziumepitaxieschicht 4 mit niedriger n-oder p-Dotierung mit einer bevorzugten Dicke von 1 bis 10 Mikrometer abgeschieden. Auf dieser 4 wird eine Padoxidschicht 5 mit einer Dicke von etwa 8 bis 25 nm abgeschieden oder durch thermisches Aufwachsen erzeugt. Auf die Padoxidschicht 5 wird eine Nitridschicht 6 mit einer Dicke von 100 bis 200 nm abgeschieden, die bei späteren Diffusionsschritten als Diffusionsbarriere dient. Auf die Nitridschicht 6 wird letztlich eine abschließende Oxidschicht 7 mit einer Dicke von etwa 1 Mikrometer abgeschieden.

Mittels an sich üblicher fotolithographischer Schritte wird eine Trenchätzmaske 5, 6, 7, die durch die Padoxidschicht 5, die Nitridschicht 6 und die abschließende Oxidschicht 7 gebildet wird, zur Definition der späteren Trenchgräben strukturiert. Die bei dem bevorzugten Ausführungsbeispiel vorgesehene Breite der späteren Trenchgräben liegt bei 1 bis 1,5 Mikrometer.

Mittels dieser Trenchätzmaske 5, 6, 7 werden die Trenches 8 bis zu der als Ätzstoppmaske dienenden, vergrabenen SiO₂-Schicht geätzt, wie dies in Fig. 2 verdeutlicht wird.

Nach dem Ätzen der Trenches 8 erfolgt eine Eindiffusion von Phosphor oder Arsen oder Bor in die Trenchseitenwände 9, wodurch die vergrabene SiO₂-Schicht 2 über die hochdotierten Trenchseitenwände 9 zur Halbleiterscheibenoberfläche hin kontaktiert wird. Bei diesem Diffusionsprozeß dient die Nitridschicht 6 als Diffusionsbarriere zum Schutz der durch sie überdeckten Halbleiterscheibenoberfläche.

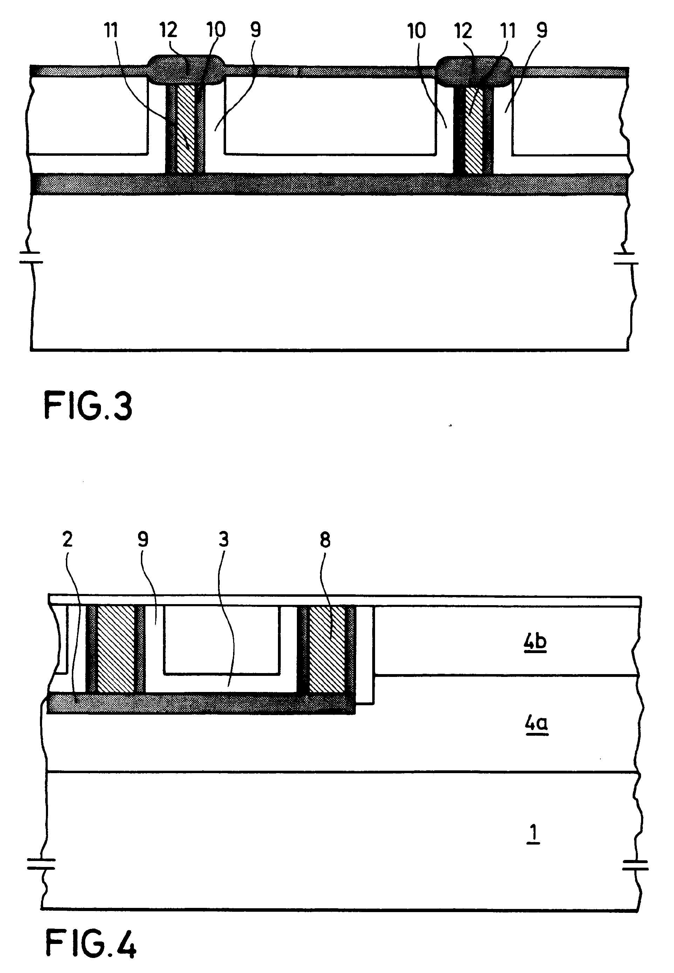

Wie in Fig. 3 zu erkennen ist, wird bei dem hier gezeigten Ausführungsbeispiel nunmehr eine Isolation der Trenchseitenwände 9 durch thermische Oxidation zum Erzeugen einer thermischen Seitenwandoxidschicht 10 vorgenommen. Anstelle der thermischen Oxidation kommt selbstverständlich auch ein Oxidabscheiden zum Erzeugen einer abgeschiedenen Seitenwandoxidschicht in Betracht.

Nunmehr werden die Trenches 8 mit Polysilizium aufgefüllt. Gleichfalls ist es möglich, die Trenches 8 durch TEOS-Oxid aufzufüllen.

Nach dem Auffüllen der Trenches 8 mit Polysilizium 11 wird die abschließende Oxidschicht 7 entfernt.

In einem folgenden Verfahrensschritt wird eine lokale Oxidation des Polysiliziums 11 im Bereich der Oberfläche der Trenches 8 an der Halbleiterscheibenoberseite vorgenommen, (vgl. Bezugszeichen 12 in Fig. 3) um die Trenches 8 zu isolieren. Hierbei dient die Nitridschicht 6 als Maske.

Es erfolgt nun das Entfernen der Nitridschicht 6. Damit ist das eigentliche Verfahren zum Erzeugen der isolierten, einkristallinen Siliziuminsel abgeschlossen. In die Siliziuminseln können nun die gewünschten Bauelemente eingebracht werden. Bei diesen Bauelementen kann es sich um NMOS- PMOS- oder Bipolar-Transistoren, quasivertikale Leistungstransistoren, laterale Hochspannungstransistoren oder andere Elemente handeln.

Wie oben erwähnt ist, kann anstelle der Verwendung des bei dem gezeigten Ausführungsbeispiel eingesetzten hochdotierten Substrates 1 ein niedrigdotiertes Substrat mit einer hochdotierten oberflächennahen Schicht, die durch Ionenimplantation und Ausheilen erzeugt ist, verwendet werden. Diese Dotierimplantation kann lokal begrenzt werden, indem zunächst auf fotolithographischem Weg eine Dotierimplantationsmaske erzeugt wird, bevor das Hochdotieren der oberflächennahen Schicht durchgeführt wird.

Ebenfalls kann bei der Sauerstoffimplantation zum Erzeugen der vergrabenen SiO₂-Schicht eine Maske verwendet werden, so daß die Siliziumepitaxieschicht außerhalb des Bereiches der vergrabenen SiO₂-Schicht 2 direkt mit dem Substrat 1 in Verbindung steht, wie dies unter anderem bei dem nachfolgend erläuterten Ausführungsbeispiel gemäß Fig. 4 der Fall ist.

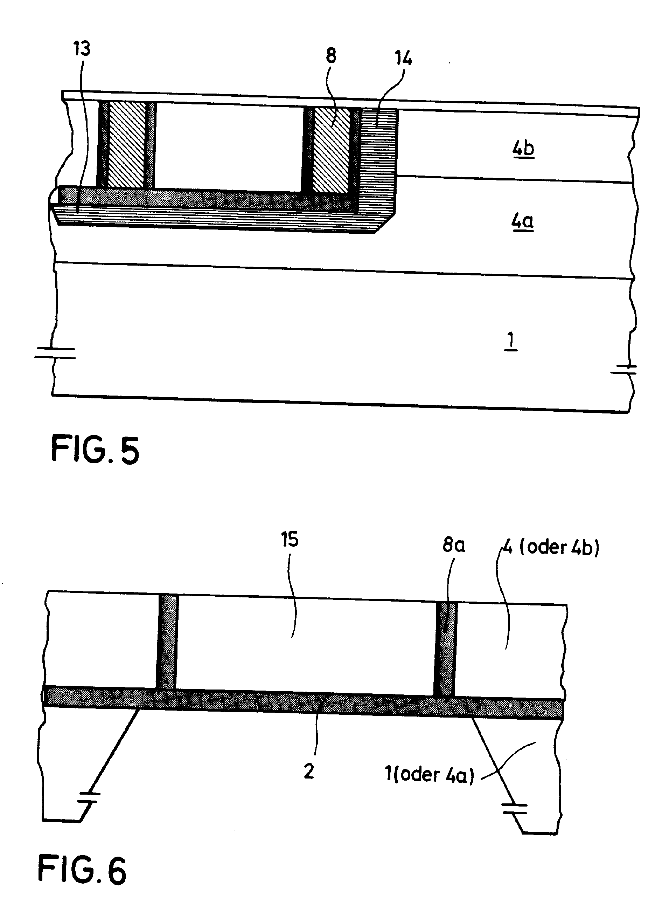

Die unter Bezugnahme auf die Fig. 1 bis 3 beschriebene Struktur ist in ihrer Spannungsfestigkeit aufgrund der Durchbruchspannung der vergrabenen SiO₂-Schicht 2 beschränkt. Bei einer Dicke dieser Schicht von 0,35 Mikrometer, wie sie bei dem bevorzugten Ausführungsbeispiel gewählt ist, ergibt sich eine Durchbruchspannung von etwa 250 V. Aus Gründen der Trenchätztechnik sollte die Trenchtiefe und damit die Dicke der epitaktisch aufgewachsenen Schicht 4 bei weniger als 10 Mikrometer liegen. Damit ist die Durchbruchspannung von außerhalb der Siliziuminseln integrierten vertikalen Bauelemente auf weniger als 150 V beschränkt. Falls es gewünscht ist, diesen außerhalb der Siliziuminseln integrierten vertikalen Bauelementen Durchbruchspannungen von oberhalb 150 V zu verleihen, kann die Durchbruchspannung bei dem zu erläuternden Ausführungsbeispiel der Fig. 4 auf Werte erhöht werden, die je nach Wahl der eingesetzten, noch zu erläuternden Technik der Oxiddurchbruchspannung der SiO₂-Schicht 2 entsprechen oder die nahezu beliebig hoch sind, wie dies bei dem Ausführungsbeispiel der Fig. 5 der Fall ist.

Bei der Ausführungsform gemäß Fig. 4 wird zunächst auf das hochdotierte Substrat 1 eine einkristalline Siliziumepitaxieschicht 4a mit einer ersten Schichtdicke aufgewachsen. Auf diesen Prozeßschritt folgt das lokale hohe Dotieren dieser ersten Siliziumepitaxieschicht 4a mittels Ionenimplantation unter Verwenden einer Dotiermaske. Nach diesem Dotieren erfolgt das Ausheilen des auf diese Weise erzeugten Schichtsystemes 1, 4a. Nunmehr wird die Sauerstoffimplantation in die dotierte Siliziumepitaxieschicht 4a zum Erzeugen der vergrabenen, isolierten SiO₂-Schicht 2 unter Verwenden der genannten Dotiermaske vorgenommen. Daraufhin wird die erzeugte Struktur thermisch ausgeheilt. Anschließend wird eine zweite Siliziumepitaxieschicht 4b mit einer zweiten Schichtdicke aufgewachsen. Die Schichtdicke der zweiten Siliziumepitaxieschicht 4b liegt bei 1 bis 10 Mikrometer. Die Dicke der erstgenannten Siliziumepitaxieschicht liegt um die Dicke der zweiten Siliziumepitaxieschicht unter der für die Spannungsfestigkeit erforderlichen Gesamtdicke. Die epitaxiale Schichtdicke auf dem vergrabenen Oxid 2 liegt also bei einem für die Durchführung der Trenchisolation geeigneten Wert von 1 bis 10 Mikrometer, während die Gesamtdicke der beiden epitaxialen Schichten 4a, 4b außerhalb des Bereiches der SiO₂-Schicht 2 der gewünschten Durchbruchspannung angepaßt ist.

Die Ausführungsform nach Fig. 4 hat also unter Beibehaltung einer Trenchtiefe von maximal 10 Mikrometer eine Spannungsfestigkeit der Siliziuminseln bis zur Durchbruchspannung des vergrabenen Oxids bzw. der SiO₂-Schicht von etwa 250 V.

Falls auch diese Spannungsfestigkeit nicht ausreichend ist, kommt die in Fig. 5 gezeigte Ausführungsform in Betracht. Zusätzlich zu den unter Bezugnahme auf Fig. 4 erläuterten Prozeßschritten wird zum Erzeugen der Struktur nach Fig. 5 vor dem Aufwachsen der zweiten epitaktischen Siliziumschicht 4b unter Verwenden einer Dotiermaske ein tiefes Implantieren von Dotierstoffen unter die SiO₂-Schicht 2 vorgenommen, so daß sich unterhalb der isolierenden SiO₂-Schicht 2 eine entgegengesetzt zum Substrat 1 dotierte Schicht 13 bildet. Diese entgegengesetzt zum Substrat 1 dotierte Schicht 13 wird mittels eines Kontaktierungsbereiches 14 zur Halbleiterscheibenoberfläche geführt. Der Kontaktierungsbereich 14 kann entweder nach dem epitaktischen Aufwachsen der zweiten Siliziumschicht 4b durch Tiefdiffusion hergestellt werden. Alternativ hierzu kommt auch eine Dotierung der Trenchseitenwand 9 für die Herstellung einer leitenden Verbindung zwischen der entgegengesetzten Substrat 1 dotierten Schicht 13 und der Scheibenoberfläche in Betracht.

Bei dem in Fig. 5 gezeigten Ausführungsbeispiel haben die Siliziuminseln eine Spannungsfestigkeit von über 1000 V. Diese hohe Spannungsfestigkeit wird dadurch erzielt, daß die Schicht 13 mit einem festen Potential beaufschlagt wird, das zu einer Polung des an der Schicht 13 angrenzenden pn-Überganges in Sperrichtung führt. Damit fällt der größte Teil der Spannung an dem im Substrat gebildeten pn-Übergang ab.

Um neben einer elektrischen Isolation auch eine thermische Isolation von auf den Halbleiterinseln ausgeführten Bauelementen zu erzielen, werden erfindungsgemäß die Strukturen nach den Fig. 6 bis 8 ausgebildet, die zusammen mit ihrem Herstellungsverfahren nachfolgend erläutert werden.

Eine thermische Isolation von Bauelementen ist beispielsweise dann von Interesse, wenn es sich bei diesen Bauelementen zum Beispiel um Transistoren bei Gassensoren, die bei über 150° C betrieben werden sollen, handelt. Wenn derartige Bauelemente thermisch isoliert angeordnet werden können, bleibt der übrige Schaltungsbereich verglichen mit dem geheizten Schaltungsbereich kühl, so daß eine geringe Heizleistung ausreichend ist.

Zur Herstellung der in Fig. 6 gezeigten Struktur bedient man sich als Ausgangsstruktur einer solchen, wie sie in den Fig. 1 bis 3 gezeigt und bezüglich ihres Herstellungsverfahrens eingangs erläutert ist. Je nach Anwendungsfall kann die hochdotierte Siliziumepitaxieschicht 3 oder die Dotierung der Seitenwand 9 entfallen. Ebenfalls kann bei dieser Variante des erfindungsgemäßen Verfahrens der Siliziumbereich 1, 4 auch ein niedrigdotierter Bereich sein. Ferner sind sowohl ganzflächige als auch partielle Sauerstoffimplantationen möglich. Zusätzlich zu den unter Bezugnahme auf die Fig. 1 bis 3 beschriebenen Verfahrensschritten werden folgende zusätzlichen Schritte ausgeführt:

Die Rückseite der Halbleiterscheibe wird mit einer rückseitigen Maske versehen, die aus Siliziumnitrid oder Oxid bestehen kann. Mittels fotolithographischer Maßnahmen wird die Maske auf der Scheibenrückseite lokal geöffnet. Die so erzeugte Ätzmaske dient zum maskierenden Begrenzen des anschließenden anisotropen Ätzens der Siliziumscheibe von ihrer Rückseite her, wobei bei diesem Ätzvorgang die vergrabene SiO₂-Schicht 2 als Ätzstopp dient. Auf diese Weise wird eine Siliziummembran 15 erzeugt, deren Dicke der Summe der Dicken der vergrabenen SiO₂-Schicht, der n⁺-Siliziumschicht 3, soweit diese vorgesehen ist, und der Siliziumepitaxieschicht 4 entspricht.

Die Dicke der erzeugten Siliziummembran 15 liegt bei 2 bis 10 Mikrometer. Ihre Dotierung ist durch die Epitaxie festgelegt. Die Größe der Membran bestimmt sich aus der Maskenöffnung auf der Scheibenrückseite und dem Ätzwinkel der anisotropen Ätzlösung, der zum Beispiel 54,7° bei einem 100-Siliziumsubstrat beträgt.

Die auf diese Weise erzeugte Halbleiterstruktur weist eine thermisch isolierte Siliziummembran 15 auf, da die Membranschicht 15 nach oben und unten durch Luft isoliert ist, und die seitliche Isolation durch wenigstens einen Trench 8 gebildet wird, der die Siliziuminsel umgibt und selbst auf der freigeätzten Fläche liegt.

Ein Wärmeübergang kann nun nur über die Luft oder den zumindest teilweise mit Oxid gefüllten Trench 8 erfolgen, der wegen der geringen Wärmeleitfähigkeit von Oxid einen hohen Wärmewiderstand hat. Je nach Wahl der für die Auffüllung des Trenches 8 verwendeten Materialien ist dieser entweder mit Oxid und Polysilizium aufgefüllt oder komplett mit einem CVD-Oxid gefüllt, wie dies zum Beispiel TEOS sein kann. Der Wärmeübergang kann nun seitlich nur über den Trench erfolgen. Ein mit einem abgeschiedenen Oxid oder thermischen Oxid oder Polysilizium gefüllter Trench mit einer effektiven Oxiddicke von 1 Mikrometer hat eine thermische Isolationswirkung, die derjenigen einer Siliziummembran mit 100 Mikrometer Weite entspricht, da die Wärmeleitfähigkeit von Oxid nur einem 100stel von derjenigen des Silizium entspricht.

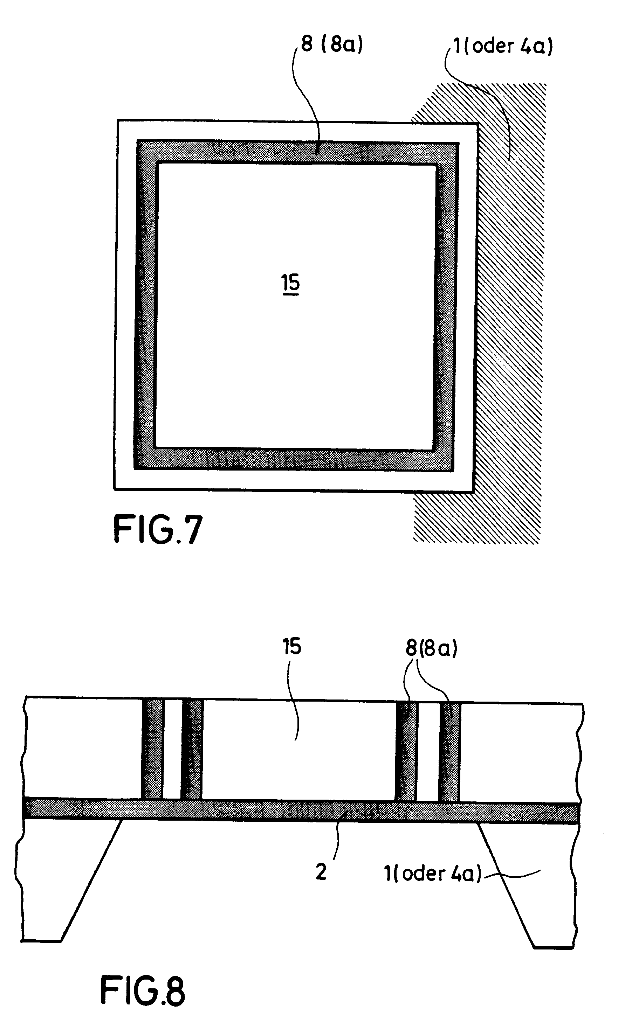

Die Draufsicht der sich ergebenden Membranstruktur ist in Fig. 7 wiedergegeben.

Falls eine gegenüber dem Ausführungsbeispiel der Fig. 6 und 7 weiter erhöhte Isolationswirkung benötigt wird, können mehrere Trenches 8 thermisch in Reihe geschaltet werden, wie dies bei dem Ausführungsbeispiel gemäß Fig. 8 zu sehen ist. Hier liegen zwei oder mehr Trenches konzentrisch zueinander um die Siliziuminsel herum, wobei sämtliche Trenches auf der freigeätzten Fläche liegen. Es ergibt sich eine sehr kompakte und damit stabile thermische Isolation einer dünnen Siliziummembran 15. Diese ist aufgrund des erfindungsgemäßen Verfahrens einkristallin. Sie kann daher beispielsweise zur Integration eines Sensorelementes mit Heizung und Temperaturmessung integriert werden.

## Patentansprüche

1. Verfahren zum Erzeugen einer isolierten, einkristallinen Siliziuminsel, mit folgenden Verfahrensschritten:
- Sauerstoffimplantation in einen hochdotierten, einkristallinen Siliziumbereich (1; 4a) zum Erzeugen einer vergrabenen, isolierten SiO₂-Schicht(2);
- Ausheilen der erzeugten Schichtstruktur (1, 2, 3);
- Abscheiden einer einkristallinen Siliziumepitaxieschicht (4, 4a, 4b) mit einer verglichen mit der Dotierung des hochdotierten Siliziumbereiches niedrigen Dotierung;
dadurch gekennzeichnet,
daß bei dem Verfahrensschritt der Sauerstoffimplantation der hochdotierte, einkristalline Siliziumbereich durch Hochdotieren einer oberflächennahen Schicht eines niederdotierten Substrates mittels Ionenimplantation und mittels anschließenden Ausheilens erzeugt wird und die Ionenimplantation vor der Sauerstoffimplantation zum Erzeugen der vergrabenen, isolierenden SiO₂-Schicht (2) erfolgt, und
daß das Verfahren ferner folgende Verfahrensschritte aufweist:
- Erzeugen einer Trenchätzmaske (5, 6, 7) auf der Siliziumepitaxieschicht (4, 4b), die eine Dotierstoffdiffusionsbarriere (6) enthält;
- Definieren der Trenches (8) mittels Fotolithographie;
- Ätzen der Trenches (8) bis zu der als Ätzstoppmaske dienenden, vergrabenen, isolierten SiO₂-Schicht (2);
- Einbringen einer hohen Dotierung in die Trenchseitenwände (9);
- Isolieren (10) der Trenchseitenwände (9); und
- Auffüllen (11) der Trenches mit einem Silizium enthaltenden Material (8).

2. Verfahren zum Erzeugen einer isolierten, einkristallinen Siliziuminsel, mit folgenden Verfahrensschritten:
- Sauerstoffimplantation in einen einkristallinen Siliziumbereich (1; 4a) zum Erzeugen einer vergrabenen, isolierten SiO₂-Schicht(2);
- Ausheilen der erzeugten Schichtstruktur (1, 4a, 2, 3);
- Abscheiden einer einkristallinen Siliziumepitaxieschicht (4, 4a, 4b) mit einer verglichen mit der Dotierung des Siliziumbereiches niedrigen Dotierung,
gekennzeichnet durch folgende Verfahrensschritte:
- Erzeugen einer Trenchätzmaske (5, 6, 7) auf der Siliziumepitaxieschicht (4, 4b), die eine Dotierstoffdiffusionsbarriere (6) enthält;
- Definieren der Trenches (8) mittels Fotolithographie;
- Ätzen der Trenches (8) bis zu der als Ätzstoppmaske dienenden, vergrabenen, isolierten SiO₂-Schicht (2);
- Isolieren (10) der Trenchseitenwände (9);
- Auffüllen (11) der Trenches mit einem Silizium enthaltenden Material (8);
- Erzeugen einer rückseitigen Maske auf der Siliziumscheibenrückseite;
- Lokales Öffnen der rückseitigen Maske mittels Fotolithographie; und
- Anisotropes Ätzen des Siliziums (1) von der Siliziumscheibenrückseite her durch die lokale Öffnung der Maske bis zu der als Ätzstopp dienenden, vergrabenen, isolierenden SiO₂-Schicht (2).

3. Verfahren nach Anspruch 2, dadurch gekennzeichnet,
daß die rückseitige Maske aus Siliziumnitrid oder Siliziumoxid besteht.

4. Verfahren nach einem der Ansprüche 1 bis 3, dadurch gekennzeichnet,
daß wenigstens zwei Trenches (8) konzentrisch angeordnet sind, und
daß die lokale Öffnung der rückseitigen Maske derart angeordnet ist, daß der durch das anisotrope Ätzen innerhalb der Siliziumscheibe erzeugte Siliziummembranbereich von den konzentrisch verlaufenden Trenches (8) umschlossen ist.

5. Verfahren nach einem der Ansprüche 1 bis 4, dadurch gekennzeichnet,
daß der Trench (8) eine in sich geschlossene Umgrenzung der Siliziuminsel bildet.

6. Verfahren nach einem der Ansprüche 1 bis 5, dadurch gekennzeichnet,
daß die Trenches (8) mit Polysilizium aufgefüllt werden, woraufhin das Polysilizium zur Isolation der Trenches (8) lokal im Bereich (12) der Halbleiterscheiben oberfläche oxidiert wird, bevor abschließend die Trenchätzmaske (5, 6, 7) zumindest teilweise (6, 7) entfernt wird.

7. Verfahren nach einem der Ansprüche 1 bis 6, dadurch gekennzeichnet,
daß der hochdotierte, einkristalline Siliziumbereich durch ein hochdotiertes Siliziumsubstrat (1) gebildet wird.

8. Verfahren nach nach einem der Ansprüche 1 bis 7, dadurch gekennzeichnet,
daß die Dotierstoffe im Falle einer n⁺-Dotierung des Siliziumbereiches Arsen oder Antimon umfassen.

9. Verfahren nach einem der Ansprüche 1 bis 8, dadurch gekennzeichnet,
daß die Dotierstoffe im Falle einer p⁺-Dotierung des Siliziumbereiches Bor umfassen.

10. Verfahren nach einem der Ansprüche 1 bis 9, dadurch gekennzeichnet,
daß die abgeschiedene einkristalline Siliziumepitaxieschicht (4, 4a, 4b) eine Dicke zwischen 1 und 10 Mikrometer hat.

11. Verfahren nach einem der Ansprüche 1 bis 10, dadurch gekennzeichnet,
daß der Verfahrensschritt des Erzeugens einer Trenchätzmaske (5, 6, 7) folgende Teilschritte umfaßt:
- Abscheiden oder thermisches Aufwachsen einer Oxidschicht (5);
- Abscheiden einer Nitridschicht (6); und
- Abscheiden einer Oxidschicht (7).

12. Verfahren nach Anspruch 11, dadurch gekennzeichnet,
daß die abgeschiedene oder thermisch aufgewachsene Oxidschicht (5) eine Dicke von 8 bis 25 nm hat.

13. Verfahren nach Anspruch 11 oder 12, dadurch gekennzeichnet,
daß die Nitridschicht (6) eine Dicke von 100 bis 200 nm hat.

14. Verfahren nach einem der Ansprüche 11 bis 13, dadurch gekennzeichnet,
daß die auf der Nitridschicht (6) abgeschiedene Oxidschicht (7) eine Dicke von ungefähr 1 Mikrometer hat.

15. Verfahren nach einem der Ansprüche 1 bis 14, dadurch gekennzeichnet,
daß die Breite der Trenchgräben (8) 1 bis 1,5 Mikrometer beträgt.

16. Verfahren nach einem der Ansprüche 1 bis 15, dadurch gekennzeichnet,
daß die Dotierstoffe für das Dotieren mittels Diffusion der Trenchseitenwände (9) Phosphor oder Arsen oder Bor umfassen.

17. Verfahren nach einem der Ansprüche 1 bis 16, dadurch gekennzeichnet,
daß die Isolation (10) der Trenchseitenwände (9) durch thermische Oxidation oder durch Oxidabscheiden erfolgt.

18. Verfahren nach einem der Ansprüche 3 bis 17, dadurch gekennzeichnet,
daß die auf der Nitridschicht (6) abgeschiedene Oxidschicht (7) nach dem Auffüllen der Trenches (8) mit Polysilizium (11) entfernt wird.

19. Verfahren nach einem der Ansprüche 11 bis 18 in direkter oder indirekter Rückbeziehung auf Anspruch 11, dadurch gekennzeichnet,
daß die Nitridschicht (6) bei der lokalen Oxidation (12) des Polysiliziums (11) zur Isolation der Trenches (8) als Maske dient, wobei die Nitridschicht (6) nach Abschluß der lokalen Oxidation (12) des Polysiliziums (11) entfernt wird.

20. Verfahren nach einem der Ansprüche 1 bis 19, gekennzeichnet durch
- das Erzeugen von Bauelementen in der Siliziuminsel.

21. Verfahren nach einem der Ansprüche 1 bis 20, gekennzeichnet durch
den Verfahrensschritt der fotolithographischen Erzeugung einer Dotierimplantationsmaske vor dem Hochdotieren der oberflächennahen Schicht zur lokalen Begrenzung des Dotierimplantationsbereiches.

22. Verfahren nach einem der Ansprüche 1 bis 21, gekennzeichnet durch
den Verfahrensschritt der Erzeugung einer Sauerstoffimplantationsmaske zur lokalen Begrenzung der vergrabenen, isolierenden SiO₂-Schicht.

23. Verfahren nach einem der Ansprüche 1 bis 22, dadurch gekennzeichnet,
daß die Verfahrensschritte der Sauerstoffimplantation in einem hochdotierten, einkristallinen Siliziumbereich und des Abscheidens der einkristallinen Siliziumschicht folgende Teilschritte umfassen:
- Abscheiden einer ersten einkristallinen Siliziumepitaxieschicht (4a) mit einer ersten Schichtdicke auf einem hochdotierten Siliziumsubstrat (1);
- Lokal hohes Dotieren der ersten Siliziumepitaxieschicht (4a) mittels Ionenimplantation unter Verwenden einer Dotiermaske;
- Ausheilen des erzeugten Schichtsystemes (1, 4a);
- Lokale Sauerstoffimplantation in die dotierte erste Siliziumepitaxieschicht (4a) zum Erzeugen der vergrabenen, isolierenden SiO₂-Schicht (2) unter Verwenden der Dotiermaske;
- Ausheilen der Sauerstoffimplantation; und
- Aufwachsen einer zweiten Siliziumepitaxieschicht (4b) mit einer zweiten Schichtdicke.

24. Verfahren nach Anspruch 23, dadurch gekennzeichnet,
daß die zweite Schichtdicke 1 bis 10 Mikrometer beträgt, und
daß die erste Schichtdicke sich aus der nötigen Schichtdicke aufgrund der geforderten Spannungsfestigkeit der Siliziuminsel vermindert um die zweite Schichtdicke ergibt.

25. Verfahren nach Anspruch 23 oder 24, gekennzeichnet durch
den Verfahrensschritt des tiefen Implantierens von Dotierstoffen in die erste Siliziumepitaxieschicht (4a) unter die vergrabene, isolierende SiO₂-Schicht (2) vor dem Verfahrensschritt des Aufwachsens der zweiten Siliziumepitaxieschicht (4b) zum Erzeugen einer entgegengesetzt zum Substrat dotierten Schicht (13); und
den Verfahrensschritt des Erzeugens eines Kontaktierungsbereiches (14) für die entgegengesetzt zu dem Substrat dotierte Schicht (13) mittels Tiefdiffusion oder mittels Dotierung der Seitenwand (9) des Trenches (8), so daß eine Kontaktierung der entgegengesetzt zum Substrat dotierten Schicht zu der Oberfläche erzeugt wird.

## Claims

1. A process for producing an insulated monocrystalline silicon island, comprising the following process steps:
- implantation of oxygen in a highly doped monocrystalline silicon region (1; 4a) in order to produce a buried insulated SiO₂ layer (2);
- annealing of the layer structure (1, 2, 3) produced;
- deposition of a monocrystalline silicon epitaxial layer (4, 4a, 4b) the doping of which is low in comparison with that of the highly doped silicon region;
characterized in
that in the process step of implantation of oxygen, the highly doped monocrystalline silicon region is produced by high doping of a layer near the surface of a low-doped substrate by means of ion implantation and subsequent annealing, and the ion implantation is carried out before the implantation of oxygen for producing the buried insulating SiO₂ layer (2),
that the process further comprises the following process steps;
- production of a trench etching mask (5, 6, 7) containing a dopant diffusion barrier (6) on the silicon epitaxial layer (4, 4b);
- definition of the trenches (8) by means of photolithography;
- etching of the trenches (8) as far as the buried insulated SiO₂ layer (2) which acts as an etching stop mask;
- introduction of a high doping into the trench sidewalls (9);
- insulation (10) of the trench sidewalls (9); and
- filling (11) of the trenches (8) with a material containing silicon.

2. A process for producing an insulated monocrystalline silicon island, comprising the following process steps:
- implantation of oxygen in a monocrystalline silicon region (1; 4a) in order to produce a buried insulated SiO₂ layer (2);
- annealing of the layer structure (1, 4a, 2, 3) produced;
- deposition of a monocrystalline silicon epitaxial layer (4, 4a, 4b) the doping of which is low in comparison with that of the highly doped silicon region;
characterized by the following process steps
- production of a trench etching mask (5, 6, 7) containing a dopant diffusion barrier (6) on the silicon epitaxial layer (4, 4b);
- definition of the trenches (8) by means of photolithography;
- etching of the trenches (8) as far as the buried insulated SiO₂ layer (2) which acts as an etching stop mask;
- insulation (10) of the trench sidewalls (9);
- filling (11) of the trenches (8) with a material containing silicon;
- production of a rear side mask on the silicon wafer back;
- local opening of the rear side mask by means of photolithography; and
- anisotropic etching of the silicon (1) from the silicon wafer back through the local opening of the mask as far as the buried insulating SiO₂ layer (2) acting as an etching stop.

3. A process according to claim 2, characterized in
that the rear side mask consists of silicon nitride or silicon oxide.

4. A process according to any one of claims 1 to 3, characterized in
that at least two trenches (8) are arranged concentrically, and
that the local opening of the rear side mask is arranged such that the silicon membrane portion produced within the silicon wafer by anisotropic etching is surrounded by the concentrically extending trenches (8).

5. A process according to any one of claims 1 to 4, characterized in
that the trench (8) constitutes a boundary of the silicon island that is closed in itself.

6. A process according to any one of claims 1 to 5, characterized in
that the trenches (8) are filled with polysilicon, whereafter the polysilicon for insulation of the trenches (8) is locally oxidized in the region (12) of the semiconductor wafer surface, before the trench etching mask (5, 6, 7) is removed finally at least in part (6, 7).

7. A process according to any one of claims 1 to 6, characterized in
that the highly doped monocrystalline silicon region is constituted by a highly doped silicon substrate (1).

8. A process according to any one of claims 1 to 7, characterized in
that the dopants in case of an n⁺ doping of the silicon region comprise arsenic or antimony.

9. A process according to any one of claims 1 to 8, characterized in
that the dopants in case of a p⁺ doping of the silicon region comprise boron.

10. A process according to any one of claims 1 to 9, characterized in
that the deposited monocrystalline silicon epitaxial layer (4, 4a, 4b) has a thickness between 1 and 10 micrometers.

11. A process according to any one of claims 1 to 10, characterized in
that the process step of producing a trench etching mask (5, 6, 7) comprises the following partial steps:
- deposition or thermal growth of an oxide layer (5);
- deposition of a nitride layer (6); and
- deposition of an oxide layer (7).

12. A process according to claim 11, characterized in
that the deposited or thermally grown oxide layer (5) has a thickness of 8 to 25 nm.

13. A process according to claim 11 or 12, characterized in
that the nitride layer (6) has a thickness of 100 to 200 nm.

14. A process according to any one of claims 11 to 13, characterized in
that the oxide layer (7) deposited on the nitride layer (6) has a thickness of approximately 1 micrometer.

15. A process according to any one of claims 1 to 14, characterized in
that the width of the trenches (8) is 1 to 1.5 micrometers.

16. A process according to any one of claims 1 to 15, characterized in
that the dopants for doping by diffusion of the trench sidewalls (9) comprise phosphorous or arsenic or boron.

17. A process according to any one of claims 1 to 16, characterized in
that the insulation (10) of the trench sidewalls (9) is effected by thermal oxidation or oxide deposition.

18. A process according to any one of claims 3 to 17, characterized in
that the oxide layer (7) deposited on the nitride layer (6) is removed after filling of the trenches (8) with polysilicon (11).

19. A process according to any one of claims 11 to 18 as directly or indirectly dependent on claim 11, characterized in
that the nitride layer (6) serves as a mask in the local oxidation (12) of the polysilicon (11) for insulation of the trenches (8), the nitride layer (6) being removed upon conclusion of the local oxidation (12) of the polysilicon (11).

20. A process according to any one of claims 1 to 19, characterized by
- the production of components in the silicon island.

21. A process according to any one of claims 1 to 20, characterized by
the process step of producing by photolithographic means a doping implantation mask for local limitation of the doping implantation region prior to the highdoping of the layer near the surface.

22. A process according to any one of claims 1 to 21, characterized by
the process step of producing an oxygen implantation mask for local limitation of the buried insulating SiO₂ layer.

23. A process according to any one of claims 1 to 22, characterized in
that the process steps of the implantation of oxygen in a highly doped monocrystalline silicon region and of the deposition of the monocrystalline silicon layer comprise the following partial steps:
- deposition of a first monocrystalline silicon epitaxial layer (4a) having a first layer thickness on a highly doped silicon substrate (1);
- local high doping of the first silicon epitaxial layer (4a) by means of ion implantation using a doping mask;
- annealing of the layer system (1, 4a) produced;
- local implantation of oxygen in the doped first silicon epitaxial layer (4a) for producing the buried insulating SiO₂ layer (2) using the doping mask;
- annealing of the oxygen implantation; and
- growing of a second silicon epitaxial layer (4b) having a second layer thickness.

24. A process according to claim 23, characterized in
that the second layer thickness is 1 to 10 micrometers; and
that the first layer thickness results from the necessary layer thickness due to the demanded electric strength of the silicon island, reduced by the second layer thickness.

25. A process according to claim 23 or 24, characterized by
the process step of deep implantation of dopants in the first silicon epitaxial layer (4a), underneath the buried insulating SiO₂ layer (2) prior to the process step of growing of the second silicon epitaxial layer (4b) for producing a layer (13) doped oppositely to the substrate; and
the process step of producing a contacting portion (14) for the layer (13) doped oppositely to the substrate, by means of deep diffusion or doping of the sidewall (9) of the trench (8) such that contacting of the layer doped oppositely to the substrate with the surface is produced.

## Revendications

1. Procédé de production d'un îlot de silicium monocristallin isolé, aux étapes de procédé suivantes:
- implantation d'oxygène dans une zone de silicium monocristalline hautement dopée (1; 4a), pour produire une couche de SiO₂ isolée enterrée (2),
- cicatrisation de la structure de couche (1, 2, 3) produite,
- dépôt d'une couche épitaxiale de silicium monocristalline (4, 4a, 4b) faiblement dopée, comparé au dopage de la zone de silicium hautement dopée,
caractérisé en ce
qu'à l'étape de procédé d'implantation d'oxygène est produite la zone de silicium monocristalline hautement dopée par haut dopage, par implantation d'ions, d'une couche rapprochée de la surface d'un substrat faiblement dopée et par cicatrisation ultérieure et que l'implantation d'ions se fait avant l'implantation d'oxygène pour la production de la couche de SiO₂ isolante enterrée (2), et
que le procédé présente, par ailleurs, les étapes de procédé suivantes:
- production d'un masque de corrosion de tranchée (5, 6, 7) sur la couche épitaxiale de silicium (4, 4b) qui contient une barrière de diffusion de dope (6),
- définition des tranchées (8) par photolitographie,
- corrosion des tranchées (8) jusqu'à la couche de SiO₂ isolée enterrée (2) servant de masque d'arrêt de corrosion,
- introduction d'un haut dopage dans les parois latérales de tranchée (9),
- isolation (10) des parois latérales de tranchée (9), et
- remplissage (11) des tranchées (8) avec un matériau contenant du silicium.

2. Procédé de production d'un îlot de silicium monocristallin isolé, aux étapes de procédé suivantes:
- implantation d'oxygène dans une zone de silicium monocristalline (1; 4a), pour produire une couche de SiO₂ isolée enterrée (2),
- cicatrisation de la structure de couche (1, 4a, 2, 3) produite,
- dépôt d'une couche épitaxiale de silicium monocristalline (4, 4a, 4b) faiblement dopée, comparé au dopage de la zone de silicium,
caractérisé par les étapes de procédé suivantes:
- production d'un masque de corrosion de tranchée (5, 6, 7) sur la couche épitaxiale de silicium (4, 4b) qui contient une barrière de diffusion de dope (6),
- définition des tranchées (8) par photolitographie,
- corrosion des tranchées (8) jusqu'à la couche de SiO₂ isolée enterrée (2) servant de masque d'arrêt de corrosion,
- isolation (10) des parois latérales de tranchée (9), et
- remplissage (11) des tranchées (8) avec un matériau contenant du silicium,
- production d'un masque côté dos sur le dos du disque de silicium,
- ouverture locale du masque côté dos par photolithographie, et
- corrosion anisotrope du silicium (1) depuis le dos du disque de silicium à travers l'ouverture locale du masque jusqu'à la couche de SiO₂ isolée enterrée (2) servant de masque d'arrêt de corrosion.

3. Procédé suivant la revendication 2, caractérisé en ce que le masque côté dos est en nitrure de silicium ou en oxyde de silicium.

4. Procédé suivant l'une des revendications 1 à 3, caractérisé en ce
qu'au moins deux tranchées (8) sont disposées de manière concentrique, et
que l'ouverture locale du masque côté dos est disposée de telle manière que la zone de membrane de silicium produite par la corrosion anisotrope dans le disque de silicium est entourée par les tranchées (8) s'étendant de manière concentrique.

5. Procédé suivant l'une des revendications 1 à 4, caractérisé en ce que la tranchée (8) constitue une délimitation fermée en soi de l'îlot de silicium.

6. Procédé suivant l'une des revendications 1 à 5, caractérisé en ce que les tranchées (8) sont remplies de polysilicium, après quoi le polysilicium est oxydé localement, pour l'isolation des tranchées (8), au niveau (12) de la surface du disque semi-conducteur, avant que le masque de corrosion de tranchée (5, 6, 7) n'est ensuite éliminé au moins partiellement (6, 7).

7. Procédé suivant l'une des revendications 1 à 6, caractérisé en ce que la zone de silicium monocristalline hautement dopée est formée par un substrat de silicium (1) hautement dopé.

8. Procédé suivant l'une des revendications 1 à 7, caractérisé en ce que, dans le cas d'un dopage n⁺ de la zone de silicium, les dopes comprennent de l'arsenic ou de l'antimoine.

9. Procédé suivant l'une des revendications 1 à 8, caractérisé en ce que, dans le cas d'un dopage p⁺ de la zone de silicium, les dopes comprennent du bore.

10. Procédé suivant l'une des revendications 1 à 9, caractérisé en ce que la couche épitaxiale de silicium monocristalline déposée (4, 4a, 4b) a une épaisseur de 1 à 10 micromètres.

11. Procédé suivant l'une des revendications 1 à 10, caractérisé en ce que l'étape de procédé de production d'un masque de corrosion de tranchée (5, 6, 7) comprend les étapes partielles suivantes:
- dépôt ou production par croissance thermique d'une couche d'oxyde (5),
- dépôt d'une couche de nitrure (6), et
- dépôt d'une couche d'oxyde (7).

12. Procédé suivant la revendication 11, caractérisé en ce que la couche d'oxyde déposée ou produite par croissance thermique (5) a une épaisseur de 8 à 25 nm.

13. Procédé suivant la revendication 11 ou 12, caractérisé en ce que la couche de nitrure (6) a une épaisseur de 100 à 200 nm.

14. Procédé suivant l'une des revendications 1 à 13, caractérisé en ce que la couche d'oxyde (7) déposée sur la couche de nitrure (6) a une épaisseur d'environ 1 micromètre.

15. Procédé suivant l'une des revendications 1 à 14, caractérisé en ce que la largeur des fossés de tranchée (8) est de 1 à 1,5 micromètre.

16. Procédé suivant l'une des revendications 1 à 15, caractérisé en ce que les dopes pour le dopage par diffusion des parois latérales de tranchée (9) comprennent du phosphore ou de l'arsenic ou du bore.

17. Procédé suivant l'une des revendications 1 à 16, caractérisé en ce que l'isolation (10) des parois latérales de tranchée (9) se fait par oxydation thermique ou par dépôt d'oxyde.

18. Procédé suivant l'une des revendications 3 à 17, caractérisé en ce que la couche d'oxyde (7) déposée sur la couche de nitrure (6) est éliminée après le remplissage des tranchées (8) avec du polysilicium (11).

19. Procédé suivant l'une des revendications 11 à 18, en référence directe ou indirecte à la revendication 11, caractérisé en ce que la couche de nitrure (6) sert de masque lors de l'oxydation locale (12) du polysilicium (11) pour l'isolation des tranchées (8), la couche de nitrure (6) étant éliminée à la fin de l'oxydation locale (12) du polysilicium (11).

20. Procédé suivant l'une des revendications 1 à 19, caractérisé par la production de composants dans l'îlot de silicium.

21. Procédé suivant l'une des revendications 1 à 20, caractérisé par l'étape de procédé de production photolithographique d'un masque d'implantation de dope avant le haut dopage de la couche rapprochée de la surface, pour la limitation locale de la zone d'implantation de dope.

22. Procédé suivant l'une des revendications 1 à 21, caractérisé par l'étape de procédé de production d'un masque d'implantation d'oxygène pour la limitation locale de la couche de SiO₂ isolante enterrée.

23. Procédé suivant l'une des revendications 1 à 22, caractérisé en ce que les étapes de procédé d'implantation d'oxygène dans une zone de silicium monocristalline hautement dopée et de dépôt de la couche de silicium monocristalline comprennent les étapes partielles suivantes:
- dépôt d'une première couche épitaxiale de silicium monocristalline (4a) d'une première épaisseur de couche sur un substrat de silicium hautement dopé (1),
- haut dopage local de la première couche épitaxiale de silicium (4a) par implantation d'ions en utilisant un masque de dopage,
- cicatrisation du système de couches (1, 4a) produit,
- implantation locale d'oxygène dans la première couche épitaxiale de silicium (4a) dopée, pour produire la couche de SiO₂ isolante enterrée (2) en utilisant le masque de dopage,
- cicatrisation de l'implantation d'oxygène, et
- production par croissance d'une seconde couche épitaxiale de silicium (4b) d'une seconde épaisseur de couche.

24. Procédé suivant la revendication 23, caractérisé en ce
que la seconde épaisseur de couche est de 1 à 10 micromètres, et
que la première épaisseur de couche résulte de l'épaisseur de couche nécessaire sur base de la rigidité diélectrique requise de l'îlot de silicium diminuée de la seconde épaisseur de couche.

25. Procédé suivant la revendication 23 ou 24, caractérisé par
l'étape de procédé d'implantation profonde de dopes dans la première couche épitaxiale de silicium (4a) sous la couche de SiO₂ isolante enterrée (2), avant l'étape de procédé de production par croissance de la seconde couche épitaxiale de silicium (4b), pour produire un couche (13) dopée contrairement au substrat (13), et
l'étape de procédé de production d'une zone de mise en contact (14) pour la couche (13) dopée contrairement au substrat (13), moyennant diffusion profonde ou moyennant dopage de la paroi latérale (9) de la tranchée (8), de sorte qu'il est produit une mise en contact de la couche dopée contrairement au substrat avec la surface.
